(19) Europäisches Patentamt
European Patent Office
Office européen des brevets

(11) Veröffentlichungsnummer: **0 042 104**
**B1**

(12) # EUROPÄISCHE PATENTSCHRIFT

(45) Veröffentlichungstag der Patentschrift: **30.01.85**

(21) Anmeldenummer: **81104259.7**

(22) Anmeldetag: **03.06.81**

(51) Int. Cl.$^4$: **G 03 F 7/02,** G 03 C 1/495, G 03 C 1/52, G 03 C 1/68, G 03 C 1/74

(54) **Lichtempfindliches Kopiermaterial und Verfahren zu seiner Herstellung.**

(30) Priorität: **14.06.80 DE 3022473**

(43) Veröffentlichungstag der Anmeldung:
**23.12.81 Patentblatt 81/51**

(45) Bekanntmachung des Hinweises auf die Patenterteilung:
**30.01.85 Patentblatt 85/05**

(84) Benannte Vertragsstaaten:
**AT BE CH DE FR GB IT LI NL SE**

(56) Entgegenhaltungen:
**Keine**

(73) Patentinhaber: **HOECHST AKTIENGESELLSCHAFT**
**Postfach 80 03 20**
**D-6230 Frankfurt am Main 80 (DE)**

(72) Erfinder: **Mohr, Dieter, Dr.**
**Prinz-Ratibor-Strasse 2**
**D-6200 Wiesbaden (DE)**
Erfinder: **Reiss, Kurt, Dr.**
**Lohmühlweg 7**
**D-6200 Wiesbaden (DE)**

**Die Akte enthält technische Angaben, die nach dem Eingang der Anmeldung eingereicht wurden und die nicht in dieser Patentschrift enthalten sind.**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 042 104 B1

**Beschreibung**

Die Erfindung betrifft ein lichtempfindliches Kopiermaterial sowie ein Verfahren zu seiner Herstellung durch Beschichten eines Schichtträgers mit einer Lösung der Bestandteile der lichtempfindlichen Schicht in einem Lösungsmittel, vorzugsweise einem organischen Lösungsmittel, und Trocknen.

Es ist üblich, lichtempfindliche Kopiermaterialien der verschiedensten Arten durch möglichst gleichmäßiges Beschichten von Schichtträgern aus Metallen, Kunststofffolien, Papier, Geweben und dgl. mit einer Lösung der Schichtbestandteile und Trocknen der Lösung unter solchen Bedingungen, daß eine möglichst gleichmäßige Schicht entsteht, herzustellen.

Als Schichtbestandteile kommen im allgemeinen lichtempfindliche bzw. photoleitfähige Verbindungen oder Kombinationen von Verbindungen, Bindemittel, Farbstoffe, Pigmente, Weichmacher, Füllstoffe, polymerisierbare Verbindungen, Stabilisatoren und dgl. in Betracht. Die Bestandteile werden vorzugsweise in organischen Lösungsmitteln, seltener in Wasser oder Gemischen von Wasser und organischen Lösungsmitteln gelöst.

Bei der Beschichtung im großtechnischen Maßstab und bei kontinuierlicher Arbeitsweise verwendet man praktisch immer Gemische von mehreren Lösungsmitteln mit unterschiedlichen Verdunstungszahlen, um einen möglichst kontinuierlichen Übergang von der flüssigen Filmphase zu der trockenen Schicht zu erreichen und eine Entmischung während des Trocknens nach Möglichkeit zu verhindern. Man erreicht das zumeist durch Kombination von guten Lösern mit Nichtlösern, wobei Dampfdruck und Verdunstungszahlen der Bestandteile so gewählt werden, daß die Nichtlöser beim Trocknen bevorzugt verdunsten. Man erhält auf diese Weise Schichten, die eine ausreichende Beschichtungsqualität aufweisen, jedoch, sofern sie nicht farblos sind, immer noch eine gewisse Ungleichmäßigkeit, die als Wolkigkeit bezeichnet wird, erkennen lassen.

Mit Wolkigkeit wird das Vorliegen von helleren und dunkleren Schichtbereichen mit Durchmessern von etwa 1 bis 10 mm nebeneinander bezeichnet. Durch rasterelektronenmikroskopische (REM) Aufnahmen von Schnitten durch Kopierschichten wurde gefunden, daß das Auftreten von Farbdichteschwankungen auf Unterschiede in der Schichtdicke zurückzuführen ist.

Es wird angenommen, daß es während des Trocknungsvorgangs bis zum Eintreten der Gelphase zu Wirbeln oder Substanzbewegungen in der noch flüssigen Schicht kommt, die durch Veränderungen der Oberflächenspannung der trocknenden Schicht verursacht werden. Durch Verdunstung des Lösungsmittels ergeben sich zwei sich gegenseitig verstärkende Faktoren, die die Oberflächenspannung der trocknenden Schicht an der Grenzfläche zur Luft erhöhen. Zum einen führt die Temperaturabnahme zu einem Ansteigen der Oberflächenspannung in einer Größenordnung von 0,1 mN/m/°C, zum anderen tritt durch die Konzentrationserhöhung der filmbildenden Substanzen in der Lösung auch eine Erhöhung der Oberflächenspannung ein.

Ausgehend von zahlreichen kleinen Quellpunkten in der darunterliegenden Schicht weniger konzentrierter Lösung, kommt es zum Durchbruch von wärmerem Material mit geringerer Oberflächenspannung an die Oberfläche. Als Folge davon bilden sich an der Oberfläche entsprechende Zentren, von denen aus sich die von unten kommende Flüssigkeit ausbreitet, bis sich die Fronten der Spreitwellen benachbarter Zentren treffen. Durch Ablenkung der Flüssigkeitsbewegung in das Schichtinnere kommt es dann zur Wirbelbildung.

Bei der Herstellung lichtempfindlicher Druckplatten, insbesondere Flachdruckplatten, bei der oft mit relativ verdünnten Lösungen niedriger Viskosität gearbeitet wird, tritt dieses Phänomen besonders stark auf. Hier werden häufig wolkige, in der Schichtdicke und Färbung uneinheitliche Schichten erhalten. Solche Unregelmäßigkeiten der Schichtdicke wirken sich auf das Druckergebnis negativ aus, insbesondere bei Platten für den rasterlosen Offsetdruck. Die Oberflächenstruktur der Platte wird dabei in Grautonstufen mit abgebildet, so daß keine einheitlichen Grauflächen gedruckt werden.

Aus Research Disclosure (1976) 145, S. 15, Nr. 14522, ist es bekannt, lithographischen Schichten eine Kombination eines nichtionischen Netzmittels, Isononylphenoxydecaglycid, une eines anionischen Netzmittels, des Ammoniumsalzes von Nonylphenoxy-polyoxyäthylen-äthylsulfat, zur Verbesserung der Vergießbarkeit der Beschichtungslösung bei guter Farbannahme zuzusetzen. Als weitere, weniger wirksame Netzmittelkombination werden das Monoäthanolaminsalz einer Alkylarylpolyglykoläthercarbonsäure und ein Polyoxyäthylen-polymethylsiloxan angegeben. Ein Netzmittel allein reicht hiernach nicht aus, um die gewünschten Eigenschaften zu erzielen; das nichtionische Netzmittel allein bewirkt eine Verschlechterung der Farbannahme und ein Tonen des Hintergrunds.

Aus der DE—OS 29 14 558 ist ein Beschichtungsverfahren bekannt geworden, bei dem die Gleichmäßigkeit der lichtempfindlichen Schichten von Flachdruckplatten dadurch verbessert wird, daß man der Beschichtungslösung ein Polymeres zusetzt, das ein Molekulargewicht von mindestens 10.000 hat und mindestens eine Fluoralkylgruppe enthält. Durch Zusatz dieser polymeren Verbindungen wird, wie in der Beschreibung angegeben ist, eine gleichmäßigere Schichtdicke erzielt. Zwar wird in der Beschreibung angegeben, daß eine Reihe von Lösungsmitteln sowohl allein als auch im Gemisch zur Herstellung der Beschichtungslösung verwendet werden können, doch werden in den

Beispielen ausschließlich Gemische von Lösungsmitteln verwendet, von denen jeweils eines niedrig und eines hoch siedet.

Auch hat die Verwendung von hochmolekularen Verbindungen mit fluorierten Seitenketten den Nachteil, daß diese Polymeren nicht mehr in allen gebräuchlichen Lösungsmitteln löslich sind, so daß die Wahl des Lösungsmittels eingeschränkt wird.

Aus der US—PS 3 779 774 ist es bekannt, den lichtempfindlichen Schichten von Vesikularfilmen bestimmte Polysiloxane, die Alkylenoxygruppen und bevorzugt Hydroxy- und Aminogruppen enthalten, zuzusetzen, um die Auflösung und Empfindlichkeit durch Bildung kleinerer Blasen zu erhöhen. Ein Einfluß der Zusätze auf die Beschichtungsqualität ist nicht beschrieben. Zu diesem Zweck wurden bereits früher, wie in der Druckschrift angegeben ist, Saponin oder ähnliche Netzmittel verwendet.

Aufgabe der Erfindung war es, ein lichtempfindliches Kopiermaterial vorzuschlagen, das sich mit einfachen Mitteln mit lichtempfindlichen Schichten hoher Qualität und Gleichmäßigkeit beschichten läßt, zu dessen Herstellung eine Vielzahl von Lösungsmitteln verwendet werden können und das gewünschtenfalls aus einer Lösung in einem einzigen Lösungsmittel hergestellt werden kann.

Die Erfindung geht aus von einem lichtempfindlichen Kopiermaterial aus einem Schichtträger und einer lichtempfindlichen Schicht, die ihre Löslichkeit in einem Entwickler bei Belichtung mit aktinischem Licht ändert und die ein Netzmittel enthält. Das erfindungsgemäße Kopiermaterial ist dadurch gekennzeichnet, daß die Schicht als Netzmittel ein oberflächenaktives Polysiloxan, das aus Dialkylsiloxan- und Oxyalkyleneinheiten besteht, in einer Menge von 0,01—10 Gew.-% enthält.

Erfindungsgemäß wird ferner ein Verfahren zum Beschichten eines Schichtträgers mit einer lichtempfindlichen Kopierschicht vorgeschlagen, bei dem die Schichtbestandteile zusammen mit einem Netzmittel in einem Lösungsmittel gelöst werden, die Lösung zu einer dünnen, gleichmäßigen Schicht auf den Träger aufgebracht und durch Verdunsten des Lösungsmittels, vorzugsweise bei erhöhter Temperatur, getrocknet wird. Das Verfahren ist dadurch gekennzeichnet, daß man der Beschichtungslösung 0,005 bis 1, vorzugsweise 0,01 bis 0,05 Gew.-% eines oberflächenaktiven Polysiloxans zusetzt, das aus Dialkylsiloxan- und Oxyalkyleneinheiten besteht.

Die erfindungsgemäß der Beschichtungslösung zugesetzten oberflächenaktiven Polysiloxane bestehen bevorzugt aus Einheiten der Formeln

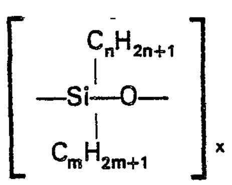 und $\left[ -C_rH_{2r}-O- \right]_y$

worin

m und n Zahlen von 1 bis 4, vorzugsweise 1 oder 2, sind,
r eine Zahl von 2 bis 5, vorzugsweise 2 oder 3,
x eine Zahl von 10 bis 100, vorzugsweise 20 bis 60, und
y eine Zahl von 25 bis 350, vorzugsweise von 50 bis 200

ist.

Die oberflächenaktiven Polysiloxane haben Molekulargewichte im Bereich von 1800 bis 40000, vorzugsweise von 3500 bis 16000.

Die Wirkung der Netzmittel hängt wesentlich von dem verwendeten Lösungsmittel ab. Dagegen spielt die chemische Natur und die Zusammensetzung der gelösten bzw. dispergierten Schichtbestandteile, insbesondere der lichtempfindlichen Substanzen, eine untergeordnete Rolle.

Für jede Schichtzusammensetzung läßt sich ein geeignetes Lösungsmittel leicht durch Vorversuche ermitteln. Dabei soll das zugesetzte Netzmittel bei Anwendung in Konzentrationen innerhalb der oben angegebenen Bereiche die Oberflächenspannung der jeweiligen Beschichtungslösung gegenüber Luft um 1 bis 6 mN/m herabsetzen. Die Oberflächenspannung der trockenen Schicht gegenüber Wasser soll durch den Netzmittelzusatz um 2 bis 10, vorzugsweise 5 bis 8 mN/m herabgesetzt werden.

Die Netzmittel reichern sich aufgrund ihrer starken oberflächenaktiven Wirkung an der Grenzfläche der Beschichtungslösung an. Dies führt besonders bei rauhen Trägeroberflächen mit sehr hoher Oberflächenspannung zu einer Verminderung der Spreittendenz der Lösung. Vermutlich wird auch das Spreiten von Flüssigkeitsphasen niedriger Trocknungsgrade und Konzentrationen auf Filmphasen höherer Trocknungsgrade durch Anreicherung der Netzmittel an den Grenzflächen weitgehend unterdrückt.

Dadurch werden wahrscheinlich Bewegungen des Flüssigkeitsfilms während der Trocknung stark gehemmt, und es entstehen gleichmäßigere Schichten nach der Trocknung.

Diese positive Wirkung zeigen jedoch nur wenige der zahlreichen bekannten Netzmittel. Als entscheidend für die Wirkung der in der vorliegenden Anmeldung beschriebenen Netzmittel wird die Kombination von Siloxaneinheiten mit Oxyalkyleneinheiten in einem Molekül angesehen. Obwohl diese

Netzmittel wegen ihrer stark oberflächenaktiven Eigenschaften und ihres relativ niedrigen Molekulargewichts in erheblichem Maße an den Grenzflächen der sich ausbildenden Schicht angereichert werden, beeinträchtigen sie weder die Bilddifferenzierung bei der Entwicklung, die Oleophilie der im Entwickler unlöslichen Bildbereiche noch die Hydrophilie der freigelegten Trägeroberfläche oder die Druckauflage der erhaltenen Druckform.

Als weiteres Maß für die Brauchbarkeit eines Netzmittels und für die Bestimmung seines geeigneten Konzentrationsbereichs in der Beschichtungslösung hat sich das Spreitvermögen der Lösung erwiesen. Dieses läßt sich leicht dadurch ermitteln, daß man eine definierte Menge der Lösung auf einen bestimmten Träger aufgibt und nach dem Trocknen bei Raumtemperatur den Durchmesser der Benetzungszone ausmißt. Als Träger verwendet man dabei zweckmäßig ein Material von sehr gleichmäßiger Rauhigkeit der Oberfläche, z.B. elektrolytisch aufgerauhtes Aluminium, da auf diesem Material die zu beobachtenden Effekte am deutlichsten hervortreten und am sichersten reproduzierbar sind.

Die auf solchem Trägermaterial ermittelten Werte für die spreitungshemmende Wirkung eines Netzmittels können mit guter Näherung auch auf das Verhalten auf einem völlig andersgearteten Trägermaterial (z.B. Polyesterfolie) übertragen werden.

Bei Zusatz der oben definierten Netzmittel zur Beschichtungslösung soll das Spreitvermögen der Lösung um 40 bis 75, vorzugsweise um 50 bis 70%, bezogen auf den Durchmesser der Benetzungszone, reduziert werden.

Bereits bei Zusatz sehr kleiner Mengen der Netzmittel (weniger als 0,1%) zu der Beschichtungslösung, die im übrigen lichtempfindliche bzw. photoleitfähige Substanzen, ggf. Bindemittel, Farbstoffe und andere üblich Bestandteile, gelöst in einem üblichen Lösungsmittelgemisch eines hoch- und niedrigsiedenden Lösungsmittels, z.B. Äthylenglykolmonomethyläther/Tetrahydrofuran oder Äthylenglykolmonomethyläther/Butylacetat/Tetrahydrofuran enthält, wird bei der Beschichtung üblicher Trägermaterialien, z.B. von Aluminium, eine wolkenfreie, optisch gleichmäßige, in Färbung und Schichtdicke einheitliche Kopierschicht erhalten. Die so hergestellten Kopierschichten übertreffen im Hinblick auf ihre Beschichtungsqualität den Standard, wie er gegenwärtig insbesondere bei vorsensibilisierten Flachdruckplatten üblich und erreichbar ist.

Als Lösungsmittel für die Beschichtungslösungen kommen in bekannter Weise u.a. Glykolderivate, Amide, chlorierte Kohlenwasserstoffe und Ketone in Betracht, z.B. Äthylenglykolmonomethyläther, Äthylenglykolmonoäthyläther, Äthylenglykolmonoisopropyläther, Dimethylformamid, Butyrolacton, Methylendichlorid, Dichloräthan oder Butanon. Die erwähnten Lösungsmittel können mit anderen Lösungsmitteln, in denen die zu lösenden Substanzen nicht unbedingt löslich sein müssen, verschnitten werden; hierzu gehören hauptsächlich Äther und Ester, wie Dioxan, Tetrahydrofuran, Butylacetat und Äthylenglykolmethylätheracetat.

In Verbindung mit den oberflächenaktiven Polysiloxanen haben sich Glykolmonoalkyläther, z.B. Äthylenglykolmonomethyläther, Glykolätherester, z.B. Äthylenglykolmethylätheracetat oder chlorierte Kohlenwasserstoffe, z.B. Dichloräthan, als gut lösende Komponente besonders bewährt.

In Ketonen, z.B. Cyclohexanon oder Butanon, als Lösungsmittel ist die vergleichmäßigende Wirkung geringer, und der Dosierungsspielraum für das Polysiloxan ist eingeschränkt. In cyclischen Äthern, z.B. Tetrahydrofuran, Estern, z.B. Butylacetat, und Alkoholen, z.B. Äthanol, ist der Einfluß der oberflächenaktiven Polysiloxane sehr gering.

Bei Zusatz der angegebenen Netzmittel zu der Beschichtungslösung wird es überraschenderweise möglich, mit einem einzigen Lösungsmittel auszukommen und Schichten von besserer Qualität zu erhalten, als man sie bisher mit Kombinationen von Lösungsmitteln, wie oben beschrieben, herstellen konnte. Es liegt auf der Hand, daß sich die Rückgewinnung und Reinigung eines einzigen Lösungsmittels technologisch wesentlichen einfacher gestaltet als die entsprechende Verarbeitung von Lösungsmittelgemischen. Insbesondere ist es wesentlich einfacher, ein relativ hochsiedendes Lösungsmittel aus der Abluft zu entfernen als ein Gemisch von hoch- und niedrigsiedenden Anteilen.

Als alleinige Lösungsmittel sind die oben genannten gut lösenden Verbindungen, besonders die Glykolmonoäther, geeignet. Sie sind aufgrund ihres guten Lösevermögens für verschiedenartige Substanzen universell für Kopierschichten unterschiedlicher Arten, z.B. Schichten auf Basis von negativ oder positiv arbeitenden Diazoverbindungen, photopolymerisierbare Schichten, photoleitfähige Schichten und andere, zu verwenden. Auch können die verschiedensten Trägermaterialien nach dem erfindungsgemäßen Verfahren mit Vorteil beschichtet werden.

Außer den genannten allgemein gültigen, durch die Verwendung eines einzigen Lösungsmittels erzielten Vorteilen bei der Herstellung werden bei Verwendung bestimmter Lösungsmittel, wie Glykolmonoäthern, z.B. von Äthylenkolmonomethyläther, als einzige Lösungsmittel von Beschichtungslösungen für die Herstellung von vorsensibilisierten Druckplatten, insbesondere Flachdruckplatten, überraschenderweise auch Vorteile im kopiertechnischen Verhalten gegenüber Materialien erzielt, die aus Lösungsmittelgemische, aber ohne Zusatz von Netzmittel, hergestellt wurden.

Je nach der Art des lichtempfindlichen Systems treten als Vorteile besserer Belichtungskontrast, geringere Entwicklungszeit, geringerer Entwicklerverbrauch, höhere Entwicklerresistenz, höhere Lichtempfindlichkeit, höhere Auflösung und/oder geringere Unterstrahlungsneigung in Erscheinung.

Diese Vorteile treten bei einem bestimmten Plattentyp in der Regel nicht alle zugleich auf und sind je nach Plattentyp unterschiedlich stark ausgeprägt.

Im Druckverhalten, wie Farbannahme, Wasserführung und Druckauflage, sind zwischen aus Glykoläthern unter Zusatz der oberflächenaktiven Polysiloxane beschichteten Flachdruckplatten und solchen, die aus Lösungsmittelgemischen ohne Netzmittelzusatz beschichtet wurden, im allgemeinen keine Unterschiede festzustellen.

Die lichtempfindlichen Schichten, die unter Verwendung der Netzmittel auf Schichtträger aufgebracht werden können, können in ihrer Natur und Zusammensetzung stark variieren. Unter lichtempfindlichen Schichten sollen hier auch solche verstanden werden, deren Lichtempfindlichkeit erst durch eine Vorbehandlung, z.B. elektrostatische Aufladung, nutzbar gemacht wird, also elektrophotographische Schichten.

Auch sollen hier Schichten einbezogen sein, die in zwei Stufen hergestellt werden, also z.B. Harz- oder Bindemittelschichten, die erste durch nachträgliches Tränken oder Imprägnieren mit einer Lösung einer lichtempfindlichen Substanz, z.B. von Dichromat oder einer Diazoverbindung, lichtempfindlich gemacht werden. In diesem Falle wird das erfindungsgemäß zugesetzte Netzmittel in der ersten Stufe, d.h. bei der eigentlichen Herstellung der Schicht, verwendet. Auch sollen sowohl fabrikatorisch hergestellte Schichten, wie bei vorsensibilisierten Druckplatten, als auch vom Anwender des lichtempfindlichen Materials selbst aufgebrachte Schichten, also Photoresistschichten oder selbstbeschichtete Druckplatten, umfaßt werden. Ebenso sind reprographische Kopierschichten, einzubeziehen, die nicht gegen sichtbares oder langwelliges UV-Licht, wohl aber gegen energiereiche Strahlung, wie Elektronen- oder Laserstrahlung empfindliche sind. Grundsätzlich findet die Erfindung auf alle reprographischen Schichten Anwendung, bei denen es auf einheitliche, homogene Beschaffenheit und Schichtdicke ankommt.

Als lichtempfindliche Systeme kommen alle diejenigen in Betracht, die durch Belichtung bzw. Bestrahlung ihre Löslichkeit in einem Entwickler verändern, also lichthärtbare (negative) oder durch Belichten löslich werdende (positive) Gemische. Es kommen ferner die elektrophotographischen Systeme in Betracht, mit deren Hilfe ein Ladungsbild, ggf. ein Tonerbild und schließlich, z.B. durch Übertragung des Ladungs- oder Tonerbilds oder durch Entschichtung der nicht vom Tonerbild bedeckten Bereiche, ein Reliefbild, z.B. für eine Druckform, erzeugt wird.

Geeignet sind vor allem lichtempfindliche Gemische auf Basis von positiv oder negativ arbeitenden Diazoverbindungen, z.B. o-Chinondiaziden oder Diazoniumsalz-Polykondensationsprodukten. Diese Gemische enthalten häufig filmbildende Harze oder Bindemittel. Geeignete positiv arbeitende Schichten dieser Art sind z.B. in den DE—OS 23 31 377, 25 47 905 und 28 28 037, negativ arbeitende Schichten des genannten Typs, z.B. in der US—PS 3 867 147 beschrieben.

Weiterhin geeignet sind positiv arbeitende Gemische auf Basis von Verbindungen mit säurespaltbaren Orthocarbonsäure- oder Acetalgruppen und photolytischen Säurespendern, wie sie z.B. in der DE—PS 26 10 842 und den DE—OS 27 18 254 und 29 28 636 beschrieben sind.

Ferner können photopolymerisierbare Gemische aus äthylenisch ungesättigten polymerisierbaren Verbindungen, Photoinitiatoren und ggf. polymeren Bindemitteln verwendet werden, wie sie z.B. in der US—PS 2 760 863, der DE—PS 20 27 467 und den DE—OS 20 64 079, 23 63 806 und 28 22 190 beschrieben sind.

Wie bereits erwähnt, können ebenfalls photoleitfähige Materialien aus anorganischen oder organischen Photoleitern und ggf. polymeren Bindemitteln verwendet werden, wie sie z.B. in den DE—PS 23 22 047, 15 22 497 und 18 11 209 und der DE—AS 27 26 116 beschrieben sind.

Als Schichtträger werden in bekannter Weise Metalle, wie Aluminium, Kupfer, verchromtes Kupfer oder Messing, Stahl oder dgl., Kunststoffolien, z.B. aus Celluloseacetat oder Polyäthylenterephthalat, kupferkaschierte Preßharzplatten und dgl. verwendet.

Die Beschichtung kann durch Antragen mit Walzen, Wannen, Breitschlitzdüsen, durch Gießen oder dgl. erfolgen. Die Art des Aufbringens der Lösung hat wenig oder gar keinen Einfluß auf die vergleichmäßigende Wirkung der zugesetzten Netzmittel.

Die nach dem erfindungsgemäßen Verfahren erhaltenen beschichteten Kopiermaterialien werden in bekannter Weise durch bildmäßiges Belichten oder Bestrahlen und Auswaschen der Nichtbildbereiche mit einem Entwickler, vorzugsweise einer wäßrigen Entwicklerlösung, in das gewünschte Reliefbild übergeführt. Dabei werden die in der Schicht enthaltenen Netzmittel zusammen mit den löslichen Schichtbereichen so vollständig von den Nichtbildstellen entfernt, daß der hier freigelegt Träger keine Neigung zum Tonen zeigt.

In der vorstehenden Beschreibung und in den Beispielen wird im wesentlichen auf die Herstellung von Flachdruckformen als wichtigstes Anwendungsgebiet des erfindungsgemäßen Materials und Verfahrens Bezug genommen. Mit Vorteil läßt sich die Erfindung auch bei der Herstellung von anderen Druckplattenarten, wie Hoch- oder Tiefdruckplatten, oder bei der Herstellung von Photoresists und anderen reprographischen Materialien anwenden, wo es auf das Aufbringen licht- oder strahlungsempfindlicher Schichten von gleichmäßiger Schichtdicke und Qualität ankommt.

Die folgenden Beispiele erläutern bevorzugte Ausführungsformen der Erfindung. Gewichtsteile (Gt) und Volumteile (Vt) stehen im Verhältnis von g zu ccm. Prozentzahlen und Mengenverhältnisse sind, wenn nichts anderes angegeben ist, in Gewichtseinheiten zu verstehen.

Beispiel 1

Auf ein elektrolytisch aufgerauhtes und anodisiertes Aluminiumband wurde durch Fließbeschichtung mittels einer Breitschlitzdüse die folgende Lösung aufgebracht:

6,6 Gt Kresol-Formaldehyd-Novolak mit dem Erweichungsbereich 105—120°C nach DIN 53 181,
1,1 Gt des 4-(2-Phenyl-prop-2-yl)-phenylesters der Naphthochinon-(1,2)-diazid-(2)-sulfonsäure-(4),
0,6 Gt 2,2'-Bis-[naphthochinon-(1,2)-diazid-(2)-sulfonyloxy-(5)]-dinaphthyl-(1,1')-methan,
0,24 Gt Naphthochinon-(1,2)-diazid-(2)-sulfochlorid-(4),
0,08 Gt Kristallviolett,
0,02 Gt eines Mischpolymerisats aus Dimethyldichlorsilan, Äthylenoxid und Propylenoxid mit einer Viskosität von 9 $cm^2$/sec bei 25°C und der Oberflächenspannung 18 mN/m,
91,36 Gt Lösungsmittelgemisch aus 4 Vt Äthylenglykolmonomethyläther, 5 Vt Tetrahydrofuran und 1 Vt Butylacetat.

Das beschichtete Band wurde im Trockenkanal bei Temperaturen bis 120°C getrocknet.

Die erhaltene Schicht hatte ein völlig gleichmäßiges, von wolkigen Unregelmäßigkeiten freies Aussehen. Es war dadurch möglich, kleine Beschichtungsfehler im Rahmen einer größeren Produktionsoperation leicht zu erkennen.

Die so hergestellten Druckplatten wurden unter einer Positivvorlage belichtet und mit einem Entwickler der folgenden Zusammensetzung entwickelt:

5,3 Gt Natriummetasilikat×9 $H_2O$,
3,4 Gt Trinatriumphosphat×12 $H_2O$,
0,3 Gt Natriumdihydrogenphosphat (wasserfrei),
91,0 Gt Wasser.

Die erhaltenen Druckformen waren kopier- und drucktechnisch fehlerfrei.

In gleicher Weise wie oben beschrieben wurden Druckplatten durch Beschichten mit einer Lösung hergestellt, die kein oberflächenaktives Polysiloxan enthielt, jedoch im übrigen die gleiche Zusammensetzung hatte wie die oben angegebene Beschichtungslösung.

Die Kopierschichten waren visuell ungleichmäßig und uneinheitlich gefärbt. Sie wiesen nach Größe und Anzahl etwa gleichmäßig verteilte hellere und dunklere Zonen auf, die in der Beschichtungsrichtung mehr oder weniger stark ausgezogen waren. Je $cm^2$ waren im Mittel etwa 3 bis 5 helle und dunkle Zonen zu erkennen. Das Aussehen derartiger Schichten wird allgemein als "wolkig" bezeichnet.

Das Kopier- und drucktechnische Verhalten der wie zuletzt beschrieben hergestellten Druckformen war das gleiche wie bei den erfindungsgemäß hergestellten Druckformen.

Beispiel 2

Es wurde wie in Beispiel 1 gearbeitet, jedoch wurde zur Herstellung der Beschichtungslösung anstelle des angegebenen Lösungsmittelgemischs die gleiche Menge Äthylenglykolmonomethyläther als einziges Lösungsmittel verwendet. Die Beschichtungsqualität war die gleiche wie in Beispiel 1.

Beim Belichten zeigten die so hergestellten Druckplatten einen deutlich höheren Bildkontrast, eine geringfügig höhere Lichtempfindlichkeit und eine geringere Unterstrahlungsneigung als die in Beispiel 1 beschriebenen Vergleichsplatten, die ohne oberflächenaktives Polysiloxan, aber mit einem Lösungsmittelgemisch hergestellt worden waren.

Beim Entwickeln der belichteten Druckplatten konnte bei einer um 20% reduzierten Menge an Entwickler die Entwicklungszeit um 14% gegenüber den oben genannten Vergleichsplatten verkürzt werden.

Hinsichtlich Farbannahme, Wasserführung und Druckauflage ist kein Unterschied zu dem Vergleich zu erkennen.

Wenn anstelle von Äthylenglykolmonomethyläther die gleiche Menge Cyclohexanon oder Methyläthylketon als einziges Lösungsmittel verwendet wurde, wurden hinsichtlich Beschichtungsqualität sowie des kopier- und drucktechnischen Verhaltens der Platten im wesentlichen gleiche Ergebnisse erhalten.

Wurde bei sonst gleicher Beschichtungslösung das Netzmittel ganz fortgelassen, so ergab sich eine extrem wolkige, ungleichmäßige, in der Beschichtungsqualität nicht akzeptable Kopierschicht.

Beispiel 3

Mit einer Lösung von

1,50 Gt des Esters aus 1 Mol 2,4-Dihydroxy-3,5-dibrom-benzophenon und 2 Mol Naphthochinon-(1,2)-diazid-(2)-5-sulfonsäure,
5,20 Gt eines Phenol-Formaldehyd-Novolaks mit 14% phenolischen OH-Gruppen und einem Erweichungspunkt von 110—120°C nach DIN 53 181,

0,20 Gt Polyvinylbutyral,
0,15 Gt Kristallviolett,
0,08 Gt Sudangelb GGN (C.I. 11 021),
0,60 Gt Tris-(β-chloräthyl)-phosphat und
0,02 Gt des in Beispiel 1 angegebenen Netzmittels in
92,25 Gt eines Lösungsmittelgemisches aus 40 Vt Äthylenglykolmonomethyläther und 50 Vt Tetrahydrofuran.

wurde eine durch Stahldrahtbürsten aufgerauhte Aluminiumfolie beschichtet und anschließend bei Temperaturen bis 110°C im Trockenkanal getrocknet.

Die so hergestellten positiv arbeitenden vorsensibilisierten Flachdruckplatten weisen eine sehr gleichmäßige lichtempfindliche Schicht auf. Die kopier- und drucktechnischen Eigenschaften der Platten sind einwandfrei.

Beispiel 4

Eine vorsensibilisierte Druckplatte wurde durch Beschichten eines Trägers wie in Beispiel 3 hergestellt, jedoch mit der Abwandlung, daß das Lösungsmittelgemisch durch die gleiche Menge Äthylenglykolmonomethyläther als einziges Lösungsmittel ersetzt wurde. Es wurde eine Druckplatte erhalten, deren Schichtqualität derjenigen von Beispiel 3 entsprach.

Die hier erhaltene Druckplatte zeichnete sich durch leichtere Entwickelbarkeit, bessere Entwicklerresistenz der Bildstellen und geringere Unterstrahlungsneigung gegenüber einer Platte aus, die wie in Beispiel 3, aber ohne Zusatz von Netzmittel hergestellt wurde. Drucktechnisch wurden etwa die gleichen Ergebnisse erhalten wie mit der Vergleichsplatte.

Beispiel 5

Eine elektrolytisch aufgerauhte und anodisierte Aluminiumplatte wurde 1 Minute in eine 60°C warme Lösung von 0,3 Gew.-% Polyvinylphosphonsäure in Wasser getaucht, danach abgespült, getrocknet und mit der nachstehenden Lösung beschichtet und getrocknet:

0,7 Gt des Polykondensationsprodukts aus 1 Mol 3-Methoxy-diphenylamin-4-diazoniumsulfat und 1 Mol 4,4'-Bis-methoxymethyl-diphenyläther, ausgefällt als Mesitylensulfonat,
3,4 Gt 85%ige Phosphorsäure,
3,0 Gt eines modifizierten Epoxidharzes, erhalten durch Umsetzen von 50 g eines Epoxidharzes mit einem Molgewicht unterhalb 1000 und 12,8 g Benzoesäure in Äthylenglykolmonomethyläther in Gegenwart von Benzyltrimethylammoniumhydroxid,
0,44 Gt feingemahlenes Heliogenblau G (C.I. 74 100),
0,02 Gt eines Mischpolymerisats und Dimethyldichlorsilan und Äthylenoxid mit etwa 15—25 Siloxaneinheiten und 50—70 Oxyäthyleneinheiten pro Molekül und dem mittleren Molgewicht von 5000,
62,0 Gt Äthylenglykolmonomethyläther,
30,6 Gt Tetrahydrofuran und
8,0 Gt Äthylenglykolmethylätheracetat.

Die erhaltene Kopierschicht war deutlich gleichmäßiger und in der Färbung einheitlicher als eine sonst entsprechende Kopierschicht, die ohne Zusatz des Netzmittels hergestellt worden war. Die Druckplatte hatte die gleichen kopier- und drucktechnischen Eigenschaften wie die Vergleichsplatte. Beide Platten wurden mit einer Lösung von

2,8 Gt $Na_2SO_4 \times 10\ H_2O$,
2,8 Gt $MgSO_4 \times 7\ H_2O$,
0,9 Gt Orthophosphorsäure (85%),
0,08 Gt phosphoriger Säure,
1,6 Gt nichtionischem Neztmittel,
10,0 Gt Benzylalkohol,
20,0 Gt n-Propanol,
60,0 Gt Wasser

entwickelt.

Beispiel 6

Es wurde wie in Beispiel 5 gearbeitet, jedoch wurde anstelle des Lösungsmittelgemischs zur Beschichtung Äthylenglykolmonomethyläther als einziges Lösungsmittel verwendet.

Es wurde eine Kopierschicht von hoher Gleichmäßigkeit, einheitlicher Schichtdicke und Färbung erhalten.

Die so erhaltene Kopierschicht wies gegenüber einer aus dem Lösungsmittelgemisch ohne Zusatz von Netzmittel hergestellten Schicht eine höhere Lichtempfindlichkeit sowie eine verbesserte Auflösung auf.

Für die Entwicklung der Schicht, die unter Zusatz von Netzmittel hergestellt worden war, war eine um 30% kürzere Entwicklungszeit erforderlich als für die Vergleichsplatte. Drucktechnisch verhielten sich beide Platten gleich.

Beispiel 7

Ein Aluminiumträger, der durch Bürsten mit einer wäßrigen Schleifmittelsuspension aufgerauht und dann mit einer wäßrigen Lösung von Polyvinylphosphonsäure behandelt worden war, wurde mit der folgenden Lösung beschichtet:

0,6 Gt des in Beispiel 5 angegebenen Diazoniumsalz-Kondensationsprodukts,
0,06 Gt Phosphonsäure (85%),
1,7 Gt Polyvinylformal (Molgewicht 30.000, 7% Hydroxygruppen, 20—27% Acetatgruppen),
2,7 Gt einer Dispersion eines Kupferphthalocyaninpigments (C.I. 74 160) in Äthylenglykolmethylätheracetat,
0,02 Gt des in Beispiel 5 angegebenen Netzmittels und
95 Gt Äthylenglykolmonomethyläther.

Die Kopierschicht zeichnete sich durch eine hohe Gleichmäßigkeit aus.

Die Schicht war nach bildmäßigem Belichten leichter entwickelbar als eine sonst entsprechende Schicht, die ohne Zusatz von Netzmittel aus einem Gemisch von 50 Gt Äthylenglykolmonomethyläther, 40 Gt Tetrahydrofuran und 10 Gt Butylacetat als Lösungsmittel hergestellt wurde. Die Entwicklung erfolgte mit der folgenden Lösung:

5,7 Gt $MgSO_4 \times 7\ H_2O$,
25,5 Gt n-Propanol,
1,1 Gt Äthylenglykolmono-n-butylester,
0,7 Gt Alkyl-polyäthoxy-äthanol,
67,0 Gt Wasser.

Beispiel 8

Die in Beispiel 7 beschriebene Beschichtungslösung wurde auf einen elektrolytisch aufgerauhten und anodisierten Aluminiumträger, der mit einer wäßrigen Lösung von Polyvinylphosphonsäure nachbehandelt worden war, aufgebracht.

Die nach Trocknen der Beschichtung erhaltene vorsensibilisierte Flachdruckplatte wies neben einer hohen Beschichtungsqualität eine etwas höhere Lichtempfindlichkeit auf und erforderte eine deutlich kürzere Entwicklungszeit bei vollständigerer Entwicklung der Feinstrichelemente im Vergleich zu einer Platte, die aus einem Lösungsmittelgemisch von 50 Gt Äthylenglykolmonomethyläther, 40 Gt Tetrahydrofuran und 10 Gt Butylacetat, aber ohne Zusatz von Netzmittel, beschichtet worden war.

Wenn in diesem Beispiel der Äthylenglykolmonomethyläther durch Dichloräthan als einziges Lösungsmittel ersetzt wurde, wurden im wesentlichen die gleichen Ergebnisse erhalten.

Beispiel 9

Eine elektrolytisch aufgerauhte und anodisierte Aluminiumplatte, die mit einer wäßrigen Lösung von Polyvinylphosphonsäure nachbehandelt worden war, wurde mit der folgenden Lösung beschichtet:

1 Gt der in Beispiel 5 angegebenen Diazoniumverbindung,
0,5 Gt des in Beispiel 7 angegebenen Polyvinylformals,
0,03 Gt eines Mischpolymerisats aus Dimethyldichlorsilan und Propylenoxid mit dem mittleren Molgewicht 7000,
98,5 Gt Äthylenglykolmonomethyläther.

Die nach dem Trocknen erhaltene vorsensibilisierte Flachdruckplatte wurde mit einem Argonlaser bei 10 Watt Leistung bildmäßig bestrahlt und mit der folgenden Lösung entwickelt:

6 Gt Magnesiumsulfat,
0,7 Gt Fettalkoholpolyglykoläther,
65 Gt Wasser,
32 Gt n-Propanol.

Zum Vergleich wurden die gleichen Schichtbestandteile aus einem Lösungsmittelgemisch von 40 Vt Tetrahydrofuran und 60 Vt Äthylenglykolmonomethyläther, jedoch ohne Zusatz des Polysiloxans auf

den Träger aufgebracht. Diese Platte hatte eine wesentlich schlechtere Schichtqualität und erforderte eine deutlich längere Belichtungszeit.

Bei Beschichtung aus Äthylenglykolmonomethyläther als einzigem Lösungsmittel und ohne Zusatz von Netzmittel wurde eine extrem wolkige Schicht mit starken Schichtdichteschwankungen erhalten.

Beispiel 10

Eine Lösung von

10 Gt 2,5-Bis-(4'-diäthylaminophenyl)-1,3,4-oxdiazol,
10 Gt eines Mischpolymerisats aus Styrol und Maleinsäureanhydrid mit dem mittleren Molekulargewicht 20.000 und der Säurezahl 180,
0,02 Gt Rhodamin FB (C.I. 45 170) und
0,02 Gt des in Beispiel 5 angegebenen Netzmittels in
300 Gt Äthylenglykolmonomethyläther

wurde auf eine elektrolytisch aufgerauhte, anodisierte und mit Polyvinylphosphonsäure behandelte Aluminiumfolie aufgebracht. Die nach dem Verdampfen des Lösungsmittels verbleibende Photoleiterschicht ist sehr gleichmäßig und weist keine sichtbaren Strukturierungen auf.

Die Schicht wurde im Dunklen mittels einer Corona auf etwa 400 V negativ aufgeladen. Die aufgeladene Platte wurde in einer Reprokamera bildmäßig belichtet und anschließend mit einem elektrophotographischen Suspensionsentwickler entwickelt, der durch Dispergieren von 3,0 g Magnesiumsulfat in einer Lösung von 7,5 g Pentaerythritharzester in 1200 ml eines Isoparaffingemischs mit einem Siedebereich von 185—210°C erhalten worden war. Nach Entfernen der überschüssigen Entwicklerflüssigkeit wurde die Platte 60 Sekunden in eine Lösung aus

35 Gt Natriummetasilikat×9 $H_2O$,
140 Vt Glycerin,
550 Vt Äthylenglykol und
140 Vt Äthanol

getaucht. Die Platte wurde dann mit einem kräftigen Wasserstrahl abgespült, wobei die nicht mit Toner bedeckten Stellen der Photoleiterschicht entfernt wurden. Die Platte ist dann druckfertig.

Da das verwendete Netzmittel eine nichtionogene Substanz ist, bleiben die Aufladbarkeit der elektrophotographischen Schicht sowie der Ladungsabfluß bei der Belichtung unbeeinflußt.

Die in der Beschichtungsqualität verbesserte Platte unterscheidet sich, was Verarbeitungseigenschaften und Druckverhalten betrifft, nicht von einer Vergleichsplatte, die aus einem Lösungsmittelgemisch aus 3 Gt Tetrahydrofuran, 2 Gt Äthylenglykolmonomethyläther und 1 Gt Butylacetat ohne Zusatz von Netzmittel beschichtet wurde.

Eine in sonst gleicher Weise, aber ohne Zusatz von Netzmittel und mit Äthylenglykolmonomethyläther als einzigem Lösungsmittel hergestellte Platte zeigte eine bereits mit bloßem Auge erkennbare Runzelstruktur.

Beispiel 11

Eine Lösung von

10 Gt des in Beispiel 5 angegebenen Diazoniumsalz-Kondensationsprodukts,
4 Gt des Azofarbstoffs aus 2,4-Dinitro-6-chlorbenzoldiazoniumsalz und 2-Methoxy-5-acetylamino-N-hydroxyäthyl-N-cyanoäthylanilin,
1 Gt Metanilgelb (C.I. 13 065),
2 Gt Phosphorsäure (85%) und
0,2 Gt des in Beispiel 5 angegebenen Netzmittels in
970 Gt Äthylenglykolmonomethyläther

wurde auf eine elektrolytisch aufgerauhte und anodisierte Aluminiumfolie aufgebracht. Es wurde eine wolkenfreie, gleichmäßige Schicht erhalten.

Beispiel 12

Eine Lösung von

28 Gt einer 50%igen wäßrigen Dispersion eines Terpolymerisats aus Vinylacetat, Äthylen und Vinylchlorid,
4 Gt einer 32%igen Kupferphthalocyanindispersion (C.I. 74 160) in Äthylenglykol/Wasser 3:1,
4 Gt des in Beispiel 5 angegebenen Diazoniumsalz-Kondensationsprodukts,

0,3 Gt Metanilgelb,
0,2 Gt Phosphorsäure (85%) und
0,2 Gt eines Mischpolymerisats mit 25—40 Dimethylsiloxaneinheiten, 120—150 Oxyäthyleneinheiten und 80—100 Oxypropyleneinheiten im Molekül und dem mittleren Molgewicht 13500 in
970 Gt Äthylenglykolmonomethyläther

wurde auf eine elektrolytisch aufgerauhte und anodisierte Aluminiumplatte aufgebracht. Dabei wurde eine wolkenfreie Kopierschicht erhalten. Wenn dagegen das Netzmittel aus der Beschichtungslösung fortgelassen wurde, wurde eine stark wolkige Schicht ungleichmäßiger Dicke erhalten.

Beispiel 13

Eine Lösung aus

14 Gt eines Mischpolymerisats aus Methylmethacrylat und Methacrylsäure mit dem mittleren Molekulargewicht 40.000 und einer Säurezahl von 90—115,
14 Gt 1,1,1-Trimethylol-äthan-triacrylat,
2 Gt 1,6-Bis-hydroxyäthoxy-hexan,
0,5 Gt 9-(p-Hydroxy-phenyl)-acridin und
0,02 Gt des in Beispiel 5 angegebenen Netzmittels in
130 Gt Äthylenglykolmonoäthyläther

wurde auf eine elektrolytisch aufgerauhte und anodisierte Aluminiumfolie aufgebracht und getrocknet.

Die erhaltene photopolymerisierbare Kopierschicht war wolkenfrei und völlig gleichmäßig.

Die Schicht wurde unter einer Vorlage mit einer 5 kW Xenon-Punktlichtlampe 1 Minute belichtet. Sie wurde dann mit einem Entwickler aus

15 Gt Natriummetasilikat×9 $H_2O$,
3 Gt Polyglykol 6000,
0,6 Gt Lävulinsäure und
0,3 Gt Strontiumhydroxid×8 $H_2O$ in
1000 Gt Wasser

1 Minute überwischt, wobei die unbelichteten Schichtbereiche entfernt wurden. Dann wurde mit Wasser abgespült, mit 1%iger Phosphorsäure fixiert und abschließend mit schwarzer Fettfarbe eingefärbt.

Wenn die gleiche Beschichtung ohne Zusatz von Netzmittel aus Äthylenglykolmonomethyläther als einzigem Lösungsmittel aufgebracht wurde, wurde eine wolkige und ungleichmäßige Kopierschicht erhalten.

Wenn ein Gemisch aus 70 Vt Äthylenglykolmonoäthyläther und 30 Vt Äthylenglykolmonobutyläther als Beschichtungslösungsmittel verwendet wurde, wurde ebenfalls eine wolkige Kopierschicht erhalten, die eine verlängerte Belichtungszeit gegenüber de Netzmittel enthaltenden Schicht erforderte.

Beispiel 14

Eine Lösung aus

25 Gt Bis-(5-äthyl-5-butyl-1,3-dioxan-2-yl)-äther des 2-Äthyl-2-butyl-1,3-propandiols,
71 Gt Kresol-Formaldehyd-Novolak wie in Beispiel 1,
3 Gt 2-(Acenaphth-5-yl)-4,6-bis-trichlormethyl-s-triazin,
0,7 Gt Kristallviolett-Base und
0,2 Gt des in Beispiel 5 angegebenen Netzmittels in
900 Gt Äthylenglykolmonomethyläther

wurde auf eine elektrolytisch aufgerauhte und anodisierte Aluminiumfolie aufgebracht und getrocknet. Die erhaltene positiv arbeitende Kopierschicht war wolkenfrei und zeichnete sich durch hohe Beschichtungsqualität aus.

Die Platte wurde in üblicher Weise unter einer Vorlage belichtet und dann mit dem in Beispiel 1 angegebenen Entwickler entwickelt.

Ähnliche Ergebnisse wurden erhalten, wenn statt des angegebenen Orthoesterderivats andere Orthocarbonsäureester, die in der DE—OS 26 10 842 beschrieben sind, oder Polyacetale verwendet wurden, wie sie in der DE—OS 27 18 254 beschrieben sind.

Beispiel 15

Eine Lösung aus

2 Gt des Esters aus 1 Mol 2,3,4-Trihydroxy-benzophenon und 3 Mol Naphthochinon-(1,2)-diazid-(2)-5-sulfonsäure,
3 Gt Zaponechtblau HFL (C.I. 74 350),
1 Gt Sudanblau II (C.I. 61 554 S) und
0,02 Gt des in Beispiel 5 angegebenen Netzmittels in
94 Gt eines Gemischs aus 30 Vt Äthylenglykolmonomethyläther, 20 Vt Methyläthylketon und 10 Vt Butylacetat

wurde auf eine Polyesterfolie aufgebracht. Es wurde eine völlig wolkenfreie, gleichmäßig gefärbte Beschichtung auf der Folie erhalten, die als Farbprüffolie verwendet werden kann. Wenn dagegen eine entsprechende Beschichtungslösung, die kein Netzmittel enthält, auf den gleichen Träger aufgebracht wurde, so wurde eine Schicht mit starken Farbdichteschwankungen erhalten.

Beispiel 16

Zur Herstellung eines Positiv-Trockenresists wurden

11,15 Gt Novolak nach Beispiel 1,
2,79 Gt Vinylacetat-Crotonsäure-Mischpolymerisat (95:5) vom Molekulargewicht 100.000,
4,18 Gt eines Mischpolymerisats aus 5:1:2 Teilen n-Hexylmethacrylat/Methylmethacrylat/Methacrylsäure mit der Säurezahl 158,
2,79 Gt Epodixharz mit dem Epoxyäquivalentgewicht 190,
2,32 Gt des Bis-Naphthochinon-(1,2)-diazid-(2)-sulfonsäure-(5)-esters des 4,4-Bis-(4-hydroxy-phenyl)-valeriansäure-3-methoxybutylesters,
0,45 Gt Naphthochinon-(1,2)-diazid-(2)-sulfochlorid-(4),
0,02 Gt des in Beispiel 1 beschriebenen Netzmittels und
0,06 Gt Kristallviolett in
48,34 Gt Äthylenglykolmonoäthyläther und
27,90 Gt Methyläthylketon

gelöst. Damit wurde eine ca. 25 µm dicke, mit einer wäßrigen Lösung von 10% Trichloressigsäure, 1% Polyvinylalkohol und 0,1% Netzmittel vorbehandelte Polyesterfolie beschichtet und getrocknet. Dabei wurde eine sehr gleichmäßige Beschichtung erhalten.

Das oben angeführte Lösungsmittel-Gemisch wurde ohne Einbuße der Beschichtungsqualität durch 76,24 Gt Äthylenglykolmonoäthyläther ersetzt.

Auf die ca. 20 µm dicke Resistschicht wurde dann eine Polyäthylen-Deckfolie zum Schutz gegen Staub und Verkratzungen aufgebracht.

Zur Herstellung von Leiterplatten wurde die Positiv-Trockenresistfolie nach Abziehen der Deckfolie in einem handelsüblichen Laminator auf eine gereinigte ca. 35 µm dicke Kupferfolie laminiert, die auf einen Isolierstoffträger aufkaschiert war. Nach Abziehen der Trägerfolie, evtl. Nachtrocknen, ca. 3 Minuten Belichten mit einem handelsüblichen Belichtungsgerät und ca. 2 Minuten Sprühentwickeln mit einem Entwickler der folgenden Zusammensetzung

0,6 Gt NaOH,
0,5 Gt $Na_2SiO_3 \times 5\ H_2O$,
1,0 Gt n-Butanol und
97,9 Gt Wasser

wurde eine ausgezeichnete bildmäßige Resistschicht erhalten. Sie widerstand nicht nur den Bedingungen von Ätzprozessen, z.B. mit $FeCl_3$, sondern war auch galvanoresistent bei der Herstellung durchkontaktierter Schaltungen, insbesondere bei dem galvanischen Aufbau von Kupfer, Nickel und Gold hintereinander.

Beispiel 17

Eine Lösung von

3,0 Gt des Bis-naphthochinon-(1,2)-diazid-(2)-sulfonsäure-(5)-esters des 4,4-Bis-(4-hydroxy-phenyl)valeriansäuremethylesters,
21,0 Gt Phenol-Formaldehyd-Novolak wie in Beispiel 3,
3,0 Gt Vinylacetat-Crotonsäure-Mischpolymerisat wie in Beispiel 16,
3,0 Gt Epoxidharz (Epoxyäquivalentgewicht um 450),
0,4 Gt Sudanblau II (C.I. Solvent Blue 35) und
0,02 Gt des in Beispiel 1 beschriebenen Netzmittels in

49,6 Gt Äthylenglykolmonoäthylätheracetat,
10,0 Gt Äthylenglykolmonoäthyläther und
10,0 Gt Butylacetat

oder in

69,6 Gt Äthylenglykolmonoäthyläther

ergab einen Positiv-Kopierlack, der sich für die Fertigung von Leiterplatten, von Kupfertiefdruckzylindern, zur Anwendung beim Formteilätzen oder für Nickelgalvanoschablonen eignet.

Beispiel 18

Eine Lösung von

2,8 Gt eines Terpolymerisats aus Methylmethacrylat, n-Hexylmethacrylat und Methacrylsäure (25:125:30) mit der Säurezahl 202,
2,8 Gt des Umsetzungsprodukts aus 1 Mol 2,2,4-Trimethyl-hexamethylendiisocyanat und 2 Mol Hydroxyäthylmethacrylat,
0,005 Gt des in Beispiel 1 angegebenen Netzmittels,
0,5 Gt Diäthylenglykolmonohexyläther,
0,03 Gt Tris-[4-(3-methyl-phenylamino)-phenyl]methylacetat und
0,025 Gt 9-Phenyl-acridin in
12 Vt Äthylenglykolmonoäthyläther

wurde auf Polyäthylenterephthalatfolie von 25 µm Stärke so aufgeschleudert, daß nach dem Trocknen (8 Minuten Fön, 3 Minuten bei 100°C im Trockenschrank) eine Schichtdicke von 25 µm erhalten wurde. Die Schicht hatte einer sehr gleichmäßige Schichtdicke und wies keine Schwankungen in der Färbung auf. Die Trockenresistfolie wurde wie in Beispiel 16 beschrieben auf einen mit Kupfer kaschierte Schichtstoffplatte aufkaschiert und belichtet. Man erhielt nach 2 Minuten Entwickeln ein sauber entwickeltes Bild der Vorlage. Die Entwicklerresistenz und Ätzresistenz sind ausgezeichnet.

**Patentansprüche**

1. Lichtempfindliches Kopiermaterial aus einem Schichtträger und einer lichtempfindlichen Schicht, die ihre Löslichkeit in einem Entwickler bei Belichtung mit aktinischem Licht ändert und die ein Netzmittel enthält, dadurch gekennzeichnet, daß die Schicht als Netzmittel ein oberflächenaktives Polysiloxan, das aus Dialkylsiloxan- und Oxyalkyleneinheiten besteht, in einer Menge von 0,01—10 Gew.-% enthält.

2. Lichtempfindliches Kopiermaterial nach Anspruch 1, dadurch gekennzeichnet, daß es das oberflächenaktive Polysiloxan in solcher Menge enthält, daß das Spreitvermögen der die Schichtbestandteile enthaltenden Beschichtungslösung auf einem Schichtträger durch den Zusatz des Polysiloxans linear um 40 bis 75% reduziert wird.

3. Lichtempfindliches Kopiermaterial nach Anspruch 1, dadurch gekennzeichnet, daß es das oberflächenaktive Polysiloxan in solcher Menge enthält, daß die Oberflächenspannung der lichtempfindlichen Schicht gegenüber Wasser um 2 bis 12 mN/m im Vergleich zur siloxanfreien Schicht herabgesetzt ist.

4. Lichtempfindliches Kopiermaterial nach Anspruch 1, dadurch gekennzeichnet, daß das oberflächenaktive Polysiloxan aus Einheiten der Formeln

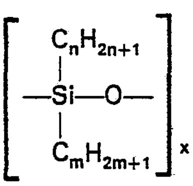

und

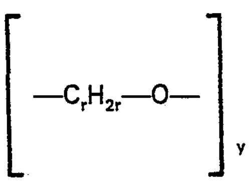

besteht, worin

m und n Zahlen von 1 bis 4,
r eine Zahl von 2 bis 5,
x eine Zahl von 10 bis 100 und
y eine Zahl von 25 bis 350

ist,

5. Lichtempfindliches Kopiermaterial nach Anspruch 1, dadurch gekennzeichnet, daß die Löslichkeit der lichtempfindlichen Schicht durch Belichten erhöht wird.

6. Lichtempfindliches Kopiermaterial nach Anspruch 5, dadurch gekennzeichnet, daß die lichtempfindliche Schicht als lichtempfindliche Verbindung ein o-Chinondiazid enthält.

7. Lichtempfindliches Kopiermaterial nach Anspruch 1, dadurch gekennzeichnet, daß die Löslichkeit der lichtempfindlichen Schicht durch Belichten herabgesetzt wird.

8. Lichtempfindliches Kopiermaterial nach Anspruch 7, dadurch gekennzeichnet, daß die Schicht als lichtempfindliche Verbindung ein Diazoniumsalz-Polykondensationsprodukt enthält.

9. Lichtempfindliches Kopiermaterial nach Anspruch 7, dadurch gekennzeichnet, daß die lichtempfindliche Schicht eine photopolymerisierbare Schicht ist.

10. Verfahren zum Beschichten eines Schichtträgers mit einer lichtempfindlichen Kopierschicht, bei dem die Schichtbestandteile zusammen mit einem Netzmittel in einem Lösungsmittel gelöst werden, die Lösung zu einer dünnen Schicht auf den Träger aufgebracht und durch Verdunsten des Lösungsmittels getrocknet wird, dadurch gekennzeichnet, daß man der Beschichtungslösung 0,005 bis 1 Gew.-% eines oberflächenaktiven Polysiloxans zusetzt, das aus Dialkylsiloxan- und Oxyalkyleneinheiten besteht.

11. Verfahren nach Anspruch 10, dadurch gekennzeichnet, daß man das oberflächenaktive Polysiloxan in solcher Menge zusetzt, daß das Spreitvermögen der Beschichtungslösung auf einem Schichtträger linear um 40 bis 75% reduziert wird.

12. Verfahren nach Anspruch 10, dadurch gekennzeichnet, daß man die Schichtbestandteile im wesentlichen in einem einzigen organischen Lösungsmittel löst.

**Revendications**

1. Matériau de reproduction photosensible constitué d'un support et d'une couche photosensible qui subit une modification de solubilité dans un matériau de développement lors d'une exposition avec une lumière actinique et qui contient un mouillant, caractérisé en ce que la couche contient comme mouillant un polysiloxane tensio-actif qui se compose de motifs dialkylsiloxane et oxyalkylène dans une quantité de 0,01—10% en poids.

2. Matériau de reproduction photosensible suivant la revendication 1, caractérisé en ce qu'il contient le polysiloxane tensio-actif dans une quantité telle que la capacité d'étalement de la solution d'enduction contenant les constituants de la couche sur un support est réduite linéairement de 40 à 75% par l'addition du polysiloxane.

3. Matériau de reproduction photosensible suivant la revendication 1, caractérisé en ce qu'il contient le polysiloxane tensio-actif dans une quantité telle que la tension superficielle de la couche photosensible est abaissée par rapport à l'eau de 2 à 12 mN/m par comparaison avec la couche exempte de siloxane.

4. Matériau de reproduction photosensible suivant la revendication 1, caractérisé en ce que le polysiloxane tensio-actif se compose de motifs répondant aux formules

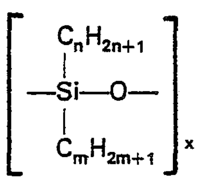

et

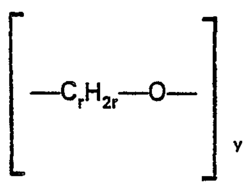

dans lesquelles

m et n sont des nombres entiers de 1 à 4,
r est un nombre entier de 2 à 5,
x est un nombre entier de 10 à 100 et
y est un nombre entier de 25 à 350.

5. Matériau de reproduction photosensible suivant la revendication 1, caractérisé en ce que la solubilité de la couche photosensible est augmentée par exposition à la lumière.

6. Matériau de reproduction photosensible suivant la revendication 5, caractérisé en ce que la couche photosensible contient comme composé photosensible un o-quinonediazide.

7. Matériau de reproduction sensible à la lumière suivant la revendication 1, caractérisé en ce que la solubilité de la couche photosensible est abaissée par exposition à la lumière.

8. Matériau de reproduction photosensible suivant la revendication 7, caractérisé en ce que la couche contient comme composé photosensible un produit de polycondensation d'un sel de diazonium.

9. Matériau de reproduction photosensible suivant la revendication 7, caractérisé en ce que la couche photosensible est une couche photopolymérisable.

10. Procédé d'enduction d'un support avec une couche de reproduction photosensible, dans lequel les constituants de la couche sont dissous en même temps qu'un mouillant dans un solvant, la solution est appliquée en couche mince sur le support et séchée par évaporation du solvant, caractérisé

en ce qu'on ajoute à la solution d'enduction 0,005 à 1% en poids d'un polysiloxane tensio-actif qui se compose de motifs dialkylsiloxane et oxyalkylène.

11. Procédé suivant la revendication 10, caractérisé en ce qu'on ajoute le polysiloxane tensio-actif dans une quantité telle que la capacité d'étalement de la solution d'enduction sur un support est réduite linéairement de 40 à 75%.

12. Procédé suivant la revendication 10, caractérisé en ce qu'on dissout les constituants de la couche essentiellement dans un solvant organique unique.

## Claims

1. A light-sensitive copying material comprising a support and a light-sensitive layer which undergoes a change of solubility in a developer upon exposure to actinic light and which contains a surfactant, characterized in that the layer contains as the surfactant a surface-active polysiloxane which comprises dialkylsiloxane units and oxyalkylene units and which is present in a quantity ranging from 0.01 to 10 percent by weight.

2. A light-sensitive copying material as claimed in claim 1, characterized in that it comprises the surface-active polysiloxane in such a quantity that the spreading capacity on a support of the coating solution containing the layer components is reduced in a linear manner by 40 to 75 percent by the addition of the polysiloxane.

3. A light-sensitive copying material as claimed in claim 1, characterized in that it comprises the surface-active polysiloxane in such a quantity that the surface tension of the light-sensitive layer towards water is reduced by 2 to 12 mN/m, as compared with a layer which is free of siloxane.

4. A light-sensitive copying material as claimed in claim 1, characterized in that the surface-active polysiloxane comprises units of the formulae

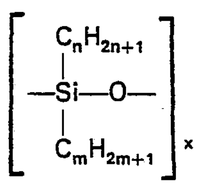

and

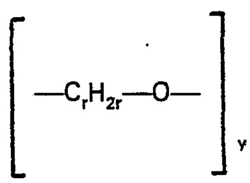

in which

m and n are integers ranging from 1 to 4,
r is an integer ranging from 2 to 5,
x is an integer ranging from 10 to 100 and
y is an integer ranging from 25 to 350.

5. A light-sensitive copying material as claimed in claim 1, characterized in that the solubility of the light-sensitive layer is increased by exposure.

6. A light-sensitive copying material as claimed in claim 5, characterized in that the light-sensitive layer contains as the light-sensitive compound an o-quinone diazide.

7. A light-sensitive copying material as claimed in claim 1, characterized in that the solubility of the light-sensitive layer is reduced by exposure.

8. A light-sensitive copying material as claimed in claim 7, characterized in that the layer contains as the light-sensitive compound a diazonium salt polycondensation product.

9. A light-sensitive copying material as claimed in claim 7, characterized in that the light-sensitive layer is a photopolymerizable layer.

10. A process for coating a support with a light-sensitive copying layer, in which the components of the layer are dissolved in a solvent together with a surfactant, the solution is applied so as to form a thin layer on the support and is then dried by evaporation of the solvent, the process being characterized in that 0.005 to 1 percent by weight of a surface-active polysiloxane comprising dialkylsiloxane units and oxyalkylene units is added to the coating solution.

11. A process as claimed in claim 10, characterized in that the surface-active polysiloxane is added in such a quantity that the spreading capacity on a support of the coating solution is reduced in a linear manner by 40 to 75 percent.

12. A process as claimed in claim 10, characterized in that the components of the layer are substantially dissolved in a single organic solvent.